Europäisches Patentamt

European Patent Office

Office européen des brevets

(19)

(11) Publication number: 0 060 021
A2

# EUROPEAN PATENT APPLICATION

(21) Application number: 82300572.3

(22) Date of filing: 04.02.82

(51) Int. Cl.³: G 01 D 5/34

(30) Priority: 17.02.81 IT 6721881

(43) Date of publication of application:
15.09.82 Bulletin 82/37

(84) Designated Contracting States:
CH DE FR GB LI

(71) Applicant: Ing. C. Olivetti & C., S.p.a.
Via G. Jervis 77
I-10015 Ivrea (Turin)(IT)

(72) Inventor: Micheletti Cremasco, Venanzio
Via Castellamonte, 10/F
I-10010 Banchette (Turin)(IT)

(74) Representative: Pears, David Ashley et al,
REDDIE & GROSE 16 Theobalds Road
London WC1X 8PL(GB)

(54) Optical transducer.

(57) An optical transducer for indicating the angular position of a rotating body with respect to a fixed structure comprising a housing 25, 26 of plastics material inside which a rigid disc 12 is rotatably mounted, this disc being connected to the rotating body and being provided with radial slots 36 arranged in two concentric annular tracks. At a position corresponding to the slots in the disc, the outer walls of the housing have seats 53, 54 provided in them during the moulding operation and these receive, in a detachable manner, a series of light sources 54 provided on one side, and on other side a corresponding series of light detector devices 56. In order to provide light beams which are orthogonal to the plane of the disc, windows 62, 63 having dimensions which are substantially equal to those of the radial slots 36 in the disc are formed in the housing at positions corresponding to those of the light sources and light detector devices. The periphery of the disc is furthermore provided with teeth 40 which partially extend outside the housing, a positioning mechanism 41 for the rotating body being adapted to cooperate with the teeth.

FIG.1

OPTICAL TRANSDUCER

The present invention relates to an optical transducer for ascertaining the angular position of a rotating body with respect to a fixed structure, such as by way of example, the shaft of a character-bearing component of an office typewriter or like machine or the shaft of a motor which controls the displacement of such a component in front of the platen of the machine. The optical transducer in accordance with the present invention comprises a disc which is connected to the rotating body, the disc being rotatably mounted inside a housing and being provided with a plurality of radial slots, and a light source and at least one corresponding element for sensing the passage of light through the slots in the disc.

One type of optical transducer is known in which a fixed mask, provided with slots having angular dimensions which are substantially equal to those of the slots of the disc, is inserted between the rotatable disc and the light source in such a way that the light generated by the latter will form one or several light beams which are collimated so as to be perpendicular to the disc. These variably energise one or more corresponding photo-electric detection means which are suitably located on the housing on the side of the disc opposite the light source, this variable energisation occurring in response to the rotation of the disc. The electrical signals which are generated by the photo-electric sensors, after processing, then give an indication of the position of the disc, of its sense of rotation and, optionally, of its velocity.

This transducer is very accurate but is fairly expensive as a result of the presence of the mask which must be fitted and positioned with a high degree of precision inside the housing.

A first object of the present invention is to provide an optical transducer which is reliable and easy to assemble, in which one or several collimated light beams can be generated in an extremely economical fashion.

In accordance with this object, the optical transducer provided by the present invention is characterised in that at least one slot, having angular dimensions which are substantially equal to those of the radial slots in the disc, is formed in the housing, at a position corresponding to that of the light source and of the photo-electric sensor device.

A further object of the present invention is to provide an optical transducer in which the disc in which the slots have been formed can also perform certain other functions which are characteristic of the machine in which it is employed, thus reducing the number of parts present in the machine, and making it less expensive and of smaller size. In accordance with this second object, the optical transducer in accordance with the invention is characterized in that the disc is rigid and is provided at its periphery with a plurality of teeth and that the housing is provided with an opening which is such that it allows the peripheral teeth of the disc to cooperate with a corresponding positioning component for the rotating body.

A further object of the present invention is to provide an optical transducer in which the light source and light detection means can easily be replaced where this is necessary, without this involving time-consuming and laborious operations.

In accordance with this third object, the optical transducer according to the present invention is characterised in that the light source and the light sensor device are housed in . a corresponding seating formed on the housing, in which they are retained in position by a corresponding releasable spring.

The invention will be described in more detail, by way of example, with reference to the accompanying drawings, in which:

Figure 1 is a side view, in cross-section of an optical transducer embodying the invention;

Figure 2 is a sectional view according to line 2-2 in Figure 1 on a reduced scale;

Figure 3 shows detail on an enlarged scale of Figure 2;

Figure 4 is a sectional view according to line 4-4 in Figure 1, on a reduced scale;

Figure 5 is a sectional view according to line 5-5 in Figure 2, on an enlarged scale;

Figure 6 shows detail on an enlarged scale of Figure 1 and

Figure 7 is a diagram showing the operation of the device in Figure 1.

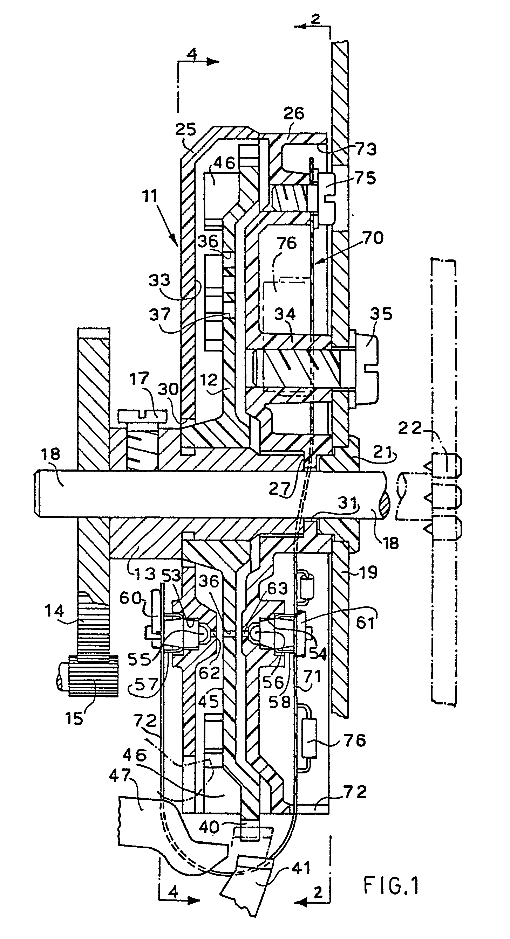

With reference now to Figure 1, the optical transducer 11 consists of a disc 12 of rigid plastics material which is mounted on a cylindrical hub 13 which in its turn is fixed to a toothed wheel 14 which engages with the pinion 15 of an electric motor which is not shown in the drawings.

The hub 13 and the disc 12 are connected by means of a set screw 17 to a shaft 18 which is rotatable in bearings, which are not shown, with respect to a fixed structure made up by a metal plate 19. A bush 21 of plastics material is inserted between the shaft 18 and the metal plate 19.

The shaft 18 is adapted to be connected, for example, to the character bearing component 22 of an office typewriter, as illustrated in our published UK Patent Application GB 2 067 472.

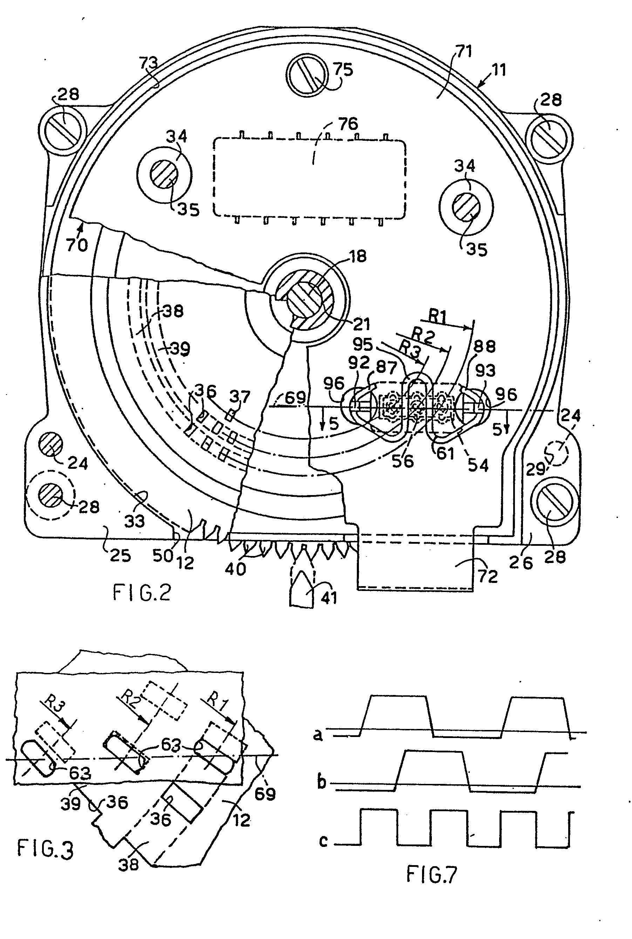

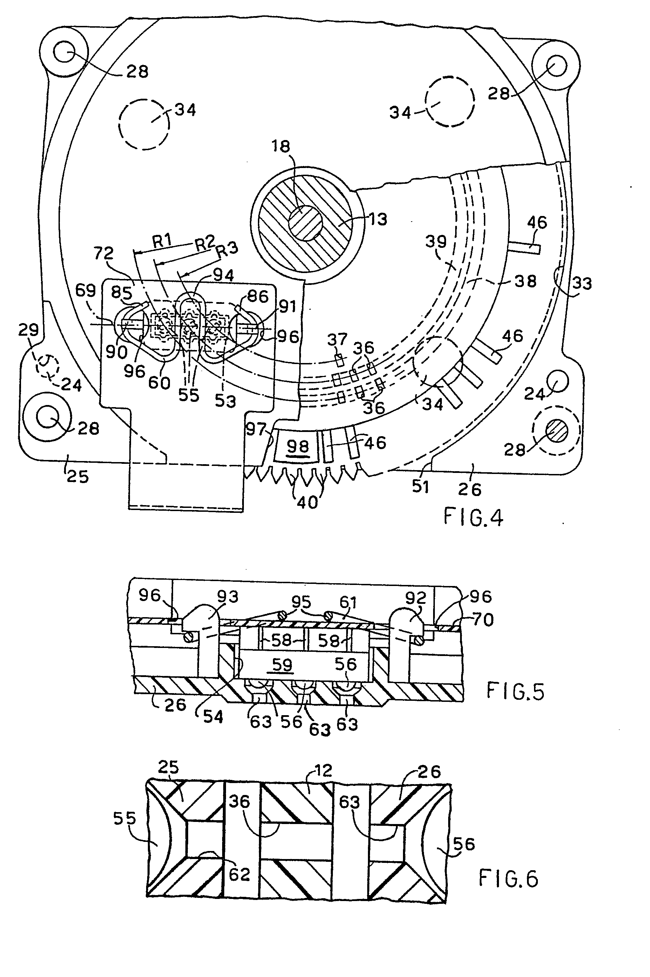

The transducer 11 further includes a housing of opaque plastics material having a shape which is substantially that of a parallelepiped (see also figures 2 and 4), and this is made up by two half-shells 25, 26, which are respectively adjacent to the toothed wheel 14 and to the fixed metal plate 19. The two half-shells 25 and 26 are held together by means of four screws · 28 (Fig 2); alternatively the two half-shells 25 and 26 can be joined together using ultrasonic welding.

The half-shell 26 carries two cylindrical pins or locating spigots 24 which are designed to mate up accurately with corresponding holes 29 in the half-shell 25 to ensure correct mutual alignment of the parts of the housing.

The two half-shells 25 and 26 have a central through passage 30, 31 respectively (Fig 1) through which the hub 13 and the shaft 18 pass, and these are shaped so as to define a substantially cylindrical cavity 33, inside which the disc 12 can rotate. The half-shell 26 is provided with an annular shoulder 27 at a position corresponding to that of the central passage 31, and has three outer spigots 34 by means of which the transducer 11 is fastened to the fixed metal plate 19, by means of screws 35.

The disc 12 is also of opaque plastics material and is provided with a plurality of radial slots 36 arranged on two annular tracks 38 and 39 (Figs 2 and 4) which are co-axial with the shaft 18 and have mean radii R1 and R2 of approximately 18 mm and 16 mm respectively. One single radial slot 37 having a radius R3 is formed on the disc 12 at a position which is closer to the centre of the disc than the slots 36.

The radial slots 36, in the particular embodiment described here are one hundred in number: fifty in the annular track 38 and fifty in the annular track 39, the angular pitch of these being $7^{o}12'$. Using this angular pitch, the ratio between the slots and solid parts of each track is 1 to 2. Additionally the slots in the track 38 are substantially in alignment with those in the track 39. The thickness of the disc in the region of the slots is about 1 mm. The incisions 36 and 37 are bordered by radial lateral edges, each have a width of about 0.5 mm and a length of about 1.3 mm and are all formed during the moulding of the disc 12.

In accordance with one characteristic of the invention, the disc 12 is additionally provided, at its periphery with a plurality of pointed teeth 40, which are angularly equidistant from each other, and these are adapted to operate with a precise positioning component 41 (Figs 1 and 2 of the disc 12 and the rotatable body 18 connected to it. Furthermore the disc 12 is provided at one of its surfaces 45 at a position corresponding to certain of the free spaces defined by the teeth 40, with radial vanges 46 (Figs 1 and 4), with which a lever 47 is designed to cooperate, the latter controlling the degree of striking force of the character bearing-component 22 connected to the shaft 18. The operation of the positioning component 41 as well as that of the lever 47 are described in detail in the patent application referred to above GB 2 067 472.

The half-shells 25 and 26 are provided at their lower side with an opening 50, 51 respectively, through which the peripheral portion of the disc 12 is able to project in order to cooperate as has been stated above, with the positioning component 41 and the lever 47.

In one example of a typical application, each half-shell 25 and 26 is shaped in such a way as to possess, at positions corresponding to the annular tracks 38 and 39 of the disc 12, with a cavity of substantially rectangular cross-section or a seating 53, 54 respectively, into which in a detachable fashion, a set of three light sources 55 is inserted, on one side, a set of three corresponding photo-electric sensor devices 56 being inserted in the other side. The sets of light sources 55 and photo-electric sensor devices 56 each have a supporting structure 59 in the form of a parallelepiped which aligns the components 55 and 56 with a pitch, or distance between centres, of 2.54 mm and are of a type which is well known and used on a wide scale for the reading of punched cards in which the elementary step is 2.54 mm, and are provided with lateral connectors 57 and 58 respectively and no further details of these will be given here.

The sets 55 and 56 are kept in their seatings 53 and 54 by means of springs 60 and 61 respectively, which will be described in detail below.

In accordance with a further characteristic of the invention a window 62 and 63 respectively, is formed on the half-shells 25 and 26 at a position corresponding to that of each light source 55 and photo-electric sensor device 56 and the dimensions of these are substantially equal to those of the slots 36 and 37. In particular, the centre of each window 62 and 63 is at a respective one of the distances R1, R2 and R3 from the axis of rotation of the disc 12. The longitudinal axes of the three windows are perfectly radial with respect to the disc.

The centres of the six windows 62 and 63 lie on an alignment plane 69 which is parallel to the axis of rotation of the disc 12, the windows 63 registering exactly with the window 62. The distance of the plane 69 from the axis of the disc is such that it causes the longer pitch of the components 55 and 56 to be congruent with the shorter radial distance of the annular paths 38 and 39 defined by the radii R1, R2 and R3. Given that the transverse dimensions of the slots 36 and of the windows 62 and 63 are identical, it is possible for the pitch of the components 55 and 56 to be appreciably greater than the radial distance of the slots 36, thus making it possible to employ components 55 and 56 having staneardized dimensions and of relatively low cost.

With reference now to Figure 3, the relationship between the angular position of the windows 63 and that of the slots 36 is such that, if one window 63 receives the maximum degree of light, this having passed through a slot 36 in the annular track 38, the other window 63 will only be illuminated to a minimal extent by light filtering from the trailing edge of the slot 36 in the annular path 39. After clockwise rotation by ¾ of an elementary step, it is now the window 63 facing the slot 36 in the annular track 39 which receives the maximum amount of illumination and the other window 63 will be illuminated by the leading edge of the slot 36 on the annular path 38.

By suitably regulating the light supplied by the light sources and using the arrangements which have been described, the output signals from the sensor devices are those indicated by $a$ and $b$ in Figure 7 which will be out of phase by $90^{\circ}$. In a typical application, each signal from the sensor device is fed into the input of a comparator the operating threshold of which is fixed at 10% of the maximum value of this signal. This makes it possible to obtain in a manner known per se, one hundred intervals $c$ which are phased at $\pm\frac{1}{4}$ of an elementary step with respect to the corrected position of the disc as defined by the positioning device 41 (Figure 2).

In Figure 1 the transducer 11 has been shown so as to emphasize the fact, in the lower half of the drawing, that the windows 62 and 63 have the same width of that as slot 36, in transverse cross-section and, at the upper part of the drawing, that the slot 36 lie on two co-axial annular paths, and that the slot 37 is arranged more inwardly than the latter.

According to one characteristic of the invention, the axial dimensions of the disc 12 and of the half-shells 25 and 26 at the regions of the slots 36 and of the windows 62 and 63 are comparable to the transverse dimensions of these same slots 36 and windows 62 and 63. The light supplied by the light sources is consequently guided by the walls of the tunnel formed by the slots and the windows and is thus collimated into extremely narrow beams. This significantly improves the signal to noise ratio of the photo-electric sensor devices and causes any axial errors or a mis-alignment of the disc 12 to only exert to a minimal influence on these signals. Additionally, the relatively large pitch of the light sources and photo-electric sensor devices and their mutual screening means that there is only a minimal influence of the light source of one pair on the light sensor of the adjacent pair.

In accordance with a further characteristic of the invention the transducer 11 is provided with a printed circuit 70 consisting of a sheet of flexible plastics material having a thickness of several tenths of millimetres, having substantially the shape of a disc 71 with a lower additional part 72 which is substantially of rectangular shape. The disc 71 is held inside a cylindrical cavity 73 formed in the part of half-shell 36 which is adjacent to the fixed metal plate 19, and is fixed to this actual half-shell 26 by means of a screw 75.

The printed circuit 70 carries the circuit components 76 which are housed inside the cavity 73 in the half-shell 26. The printed circuit 70 is additionally kept constantly in contact with the set of photo-electric sensor devices 56 by means of the spring 61. The additional lower portion 72 is folded upwardly (see figures 1 and 4) in order to make contact with the set of light sources 55 under the action of the spring 60.

The springs 60 and 61 which are identical to each other have two lateral arms 85 and 86 and respectively 87 and 88 which are hooked into corresponding hook members 90 and 91, respectively 92 and 93 of the half-shells 25 and 26, these projecting from the printed circuit 70 through holes 96. A central portion 94, 95 rrespectively of the springs 60 and 61 cooperates with the printed circuits 70 both in order to guarantee electrical contact between the conductive paths of the actual circuit 70 and the lateral connectors 57 and 58 of the light sources 55 and the photo-electric sensor devices 56 and for providing a spring fofce on the latter when they are inside their seatings 53 and 54, thus keeping them in their normal position.

Assembly of the optical transducer as described above is as follows:

First of all, the hub 13 to which the toothed wheel is fixed, is inserted inside the central passage 30 of the half-shell 25, after which the disc 12 is assembled on to the actual hub 13 as is shown in Figure 1.

Next, the half-shell 26 is fixed to the half-shell 25, their correct positioning being guaranteed by the spigots 24, after which they are locked together using for example the screws 28.

Then the sets of devices 55, 56 are inserted into their seatings 53 and 54, after which the printed circuit 70 is fitted on to the half-shell 26 and the springs 60' and 61 are engaged with their corresponding hook members 90, 91 and 92, 93. It should be noted that in this fashion, possible replacement of the sets of light sources and photo-sensor devices 55 and 56 is extremely simple and does not necessitate the use of special tools. Additionally, electrical contact between the connectors 57, 58 and the printed circuit 70 is ensured without the need to employ soldering.

The transducer 11, once it has been completely assebled, is mounted on the rotating body 18. The zero position of the disc with respect to the half-shells is checked through a windiw 97 in the half-shell 25 by means of which it is possible to view a scale 98 giving data for locating the disc 12, formed between certain of the vanes 46. The hub 13 and the disc 12 are assembled on to the cylindrical bush 21, thus ensuring that the disc 12 and the half-shells 25 and 26 are co-axial with respect to each other. The transducer 11 is then fixed to the metal plate 19 by means of screws 35. The correct axial positioning of the disc 12 with respect to the half;shells 25 and 26 is obtained by inserting the hub 13 into the hole 30 until it bears against the shoulder 27 of the half-shell 26. Finally, the disc 12 and the hub 13 are locked to the shaft 13 by means of the screw 17, after it has been correctly positioned angularly with respect to the housing which has already been attached to the fixed structure 19.

Operation of the transducer 11 in accordance with the invention is conventional and will consequently not be described here in detail.

From the present invention it will be clearly seen that as the dimensions of the windows 62 and 63 are substantially identical to those of the slots 36 and 37, the former being provided directly in the housing at a position corresponding to that of each light source 55 and photo-electric sensor 56, beams of light which are orthogonal to the disc 12 will be generated without the need to employ a mask bearing slots. In this way possible axial displacements of the shaft 18 and of the disc 12 connected to it do not have a detrimental effect on the determination of their position and angular velocity.

It will furthermore be clear that the disc 12 is rigid and is provided at its periphery with a plurality of teeth 40 and that the housing is provided with an opening 50, 51 through which the teeth 40 can to project in order to cooperate with a corresponding positioning component 41 of the rotating body 18.

CLAIMS

1.      Optical transducer for indicating the angular position of a rotating body with respect to a fixed structure, comprising a housing inside which a disc which is connected to the rotating body is rotatably mounted and is provided with a plurality of radial slots, a light source and a corresponding element adapted to sense the passage of light through the slots in the disc, characterised in that at least one window (62 or 63) having a width substantially equal to that of the slots (36) is formed in the housing (25, 26) at a position corresponding to that of the light source (55) and/or the light sensing means (56)..

2.      Optical transducer according to claim 1, characterised in that the disc (12) is rigid and is provided at its periphery with a plurality of teeth (40) associated with the slots (36), and in that the housing (25, 26) has an opening adapted to allow the peripheral teeth to cooperate with a corresponding positioning component for the rotating body.

3.      Optical transducer according to claim 1 or 2, characterised in that the walls of the housing (25, 26) at opposing sides with respect to the disc (12), have seatings (53, 54) formed in them in which the light source (55) and light sensing means (56) are releasably housed, each of them being held in position therein by a corresponding spring (60 or 61).

4.      Optical transducer according to any of the preceding claims, characterised in that the disc (12) is of an opaque material and the axial depth of the slots (36) in the disc is greater than the width of the slots.

5.      Optical transducer according to any of the preceding claims, characterised in that the axial depth of the windows (62 or 63) is substantially equal to the width of the slots (36).

6.      Optical transducer according to claims 4 and 5, characterised in that the disc (12) and housing (25, 26) are of an opaque plastics material.

7.      Optical transducer according to any of the preceding claims, characterised in that a single window (62 or 63) is provided for each light source (55) and for each light sensing means (56), the axis of the window being aligned with the optical axis of the corresponding light source or light sensing means

8.      Optical transducer for indicating the angular position of a rotating body with respect to a fixed structure, comprising a disc connected to the rotating body and provided with a plurality of slots, at least one light source and light detecting means for detecting the passage of light through the slots in the disc, and a housing inside which the disc is rotatable and which supports the light source and light sensing means at opposing sides with respect to the disc, characterised by a printed circuit (70) provided with a flexible support having conductive paths carried by the support and having regions of contact between the terminals (57, 58) of the light source and light sensing means, and by locating components for the flexible support on the housing so as to determine the position of the support with respect to the disc and to maintain the regions of contact on the printed circuit in contact with the terminals of the light source and light sensing means.

9.      Optical transducer according to claim 8, characterised in that the seatings (53, 54) are formed in the walls of the housing on opposite sides thereof with respect to the disc (12), in which seatings the light source (55) and light sensing means (56) are detachably housed, a corresponding spring (60 or 62) being provided which acts on the flexible support (70) for maintaining the light source and light sensing means located in the seatings, via the regions of contact of the conductors of the circuit.

10.    Optical transducer according to claim 9, characterised in that hooks (90, 91) are provided on the housing (25, 26) which project from holes in the flexible support (70) and on to which the spring (60 or 62) is fastened.

11.    Optical transducer in accordance with claim 8, 9 or 10, characterised by the presence of an enclosed space (73) outside the housing adapted to hold components (76) of the printed circuits which are fixed to its respective conductors.

12.    Optical transducer for indicating the angular position of a rotating body with respect to a fixed structure, comprising a shell inside which a disc connected to the rotating body is rotatably mounted and provided with a plurality of radial slots, a set of light source means and a corresponding set of detection means adapted to detect the passage of light through the slots in the disc at varying phase conditions with respect to the fixed structure; characterised by a pair of intermediate supports (59) on which there are mounted in mutual association, the respective light source means (55) and corresponding light detection means (56(, spaced at a fixed distance from each other, and by a pair of seatings (53, 54) in the housing (25, 26) adapted to correctly locate the pair of intermediate supports, and in that the slots (36) are distributed over a set of annular tracks (38, 39) on the disc, the sets being associated with the sets of light source and light sensing means, their mutual radial spacing being substantially less than the spacing between adjacent light source means and adjacent light sensing means and the positions of the pair of seatings with respect to the axis of the disc being such as to allow, for each annular path, the alignment of slot with the light source and light sensing means associated with the annular track.

13.    Optical transducer according to claim 12, characterised in that the slots (36) are distributed over two annular tracks (38, 39) so as not to be adjacent but to be substantially in alignment along a radial axis.

0060021

- 13 -

14.     Optical transducer for carrying out angular positioning of a rotating body with respect to fixed structure, comprising a housing inside which a disc connected to the rotating body is rotatably mounted and is provided with a plurality of radial incisions, a light source means and a corresponding means suitable for detecting the passage of light through the incisions in the disc, characterized in that the disc (12) is rigid and is provided at its periphery with a plurality of teeth (40) associated with the slots (36) and in that the housing (25, 26) has an opening which allows the peripheral teeth to cooperate with a corresponding positioning component for the rotating body.

15.     Optical transducer according to claim 12, characterised in that the housing (25, 26) is located on the axis of a character-bearing component of a typewriter.

FIG.1

FIG.2

FIG.3

FIG.7

FIG.4

FIG.5

FIG.6